(19) Europäisches Patentamt / European Patent Office / Office européen des brevets

(11) **EP 2 388 601 B1**

(12) **EUROPEAN PATENT SPECIFICATION**

(45) Date of publication and mention
of the grant of the patent:
**27.03.2013 Bulletin 2013/13**

(51) Int Cl.:
***G01R 29/26*** *(2006.01)*

(21) Application number: **10007805.4**

(22) Date of filing: **27.07.2010**

(54) **Method and device for evaluation of phase noise in OFDM signals**

Verfahren und Vorrichtung zur Einschätzung von Phasenrauschen in OFDM-Signalen

Procédé et dispositif pour l'évaluation du bruit de phase dans des signaux OFDM

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **19.05.2010 EP 10005257**

(43) Date of publication of application:
**23.11.2011 Bulletin 2011/47**

(73) Proprietor: **Rohde & Schwarz GmbH & Co. KG
81671 München (DE)**

(72) Inventors:
• **Balz, Christoph
81543 München (DE)**
• **Osterloh, Gernot
82178 Puchheim (DE)**

(74) Representative: **Körfer, Thomas et al
Mitscherlich & Partner
Patent- und Rechtsanwälte
Postfach 33 06 09
80066 München (DE)**

(56) References cited:
• **Heung-Gyoon Ryu, Ying-Shan Lee: "Phase Noise Analysis of the OFDM Communication System by the Standard Frequency Deviation", IEEE Transaction on Consumer Electronics, 20 June 2003 (2003-06-20), pages 41-47, XP002644679, Retrieved from the Internet: URL:http:// ieeexplore.ieee.org/stamp/stamp .jsp? tp=&arnumber=1205454 [retrieved on 2011-06-23]**
• **ANGRISANI L ET AL: "A Digital Signal Processing Instrument for Real-Time Phase Noise Measurement", IEEE TRANSACTIONS ON INSTRUMENTATION AND MEASUREMENT, IEEE SERVICE CENTER, PISCATAWAY, NJ, US, vol. 55, no. 10, 1 October 2008 (2008-10-01), pages 2098-2107, XP011227128, ISSN: 0018-9456**

## Description

The invention relates to evaluating the phase noise in signals, especially OFDM signals.

When generating or transmitting OFDM Signals, many different impairments may degrade the overall signal quality. Common TV test receivers are able to recognize a lot of possible reasons of such errors. For instance a carrier frequency offset is calculated and compensated by the test receiver. However, with existing methods and devices, there is no possibility to directly detect and identify phase noise issues of the incoming signal.

Apart from TV test receivers the measurement of phase noise is known. The German patent application DE 10 2006 019 759 A1 shows a device and the method for measuring phase noise. The device and the method shown however require a great material effort. The method and device shown there cannot be integrated into a TV test receiver.

In ANGRISANI L ET AL : "A Digital Signal Processing Instrument for Real-time phase noise Measurement, IEEE Transactions on Center, PISCATAWAY, NJ, US, vol. 55, no. 10, 1 October 2008, pages 2098-2107,a device and a method for measuring phase noise in frequency domain is disclosed.

Accordingly, the object of the invention is to create a device and method, which is able to measure and display phase noise while requiring little production effort.

The object of the present invention is solved by the features of claim 1 for the device and by the features of claim 7 for the method. The dependent claims contain further developments.

The present invention is based on the finding that frequency errors within OFDM signals are displayed in an unhandy manner in state of the art measurement receivers. Especially the source of such errors cannot be derived from the measurement results displayed.

By transforming a frequency deviation into the frequency domain and differentiating it a phase noise over a frequency range is determined according to the present invention. Still this representation of the errors within the signal is not very convenient. By scaling the signal using a scaling factor a very easily understandable measure for example in dB over a frequency range is reached.

An inventive device for measuring phase noise in OFDM signals comprises first signal processing means, second signal processing means and scaling means. The first signal processing means determine a frequency deviation of the OFDM signal over time. The second signal processing means transform the frequency deviation into the frequency domain. The second signal processing means determine a phase deviation of the OFDM signal over a frequency range. The scaling means scale the phase deviation to a modulation error rate over a frequency range using a scaling factor. An easily understandable representation of the errors within the OFDM signal is therefore created.

Exemplary embodiments of the inventions are now further explained with respect to the drawings, in which,

Fig. 1    shows a block diagram of a first exemplary embodiment of the inventive test receiver;

Fig. 2    depicts a first exemplary display readout;

Fig. 3    shows a second exemplary display readout;

Fig. 4    displays a flow chart of a first exemplary embodiment of the inventive method;

Fig. 5    shows a flow chart of a second exemplary embodiment of the inventive method;

Fig. 6    shows a block diagram of a second exemplary embodiment of the inventive test receiver, and

Fig. 7    displays a flow chart of a third exemplary embodiment of the inventive method.

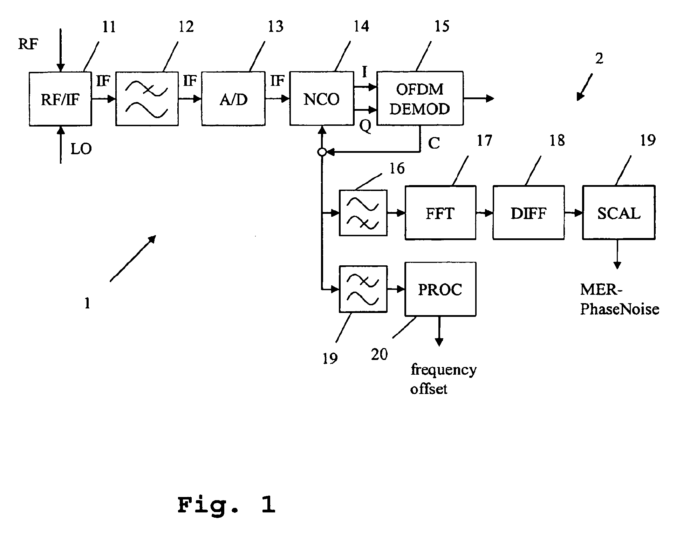

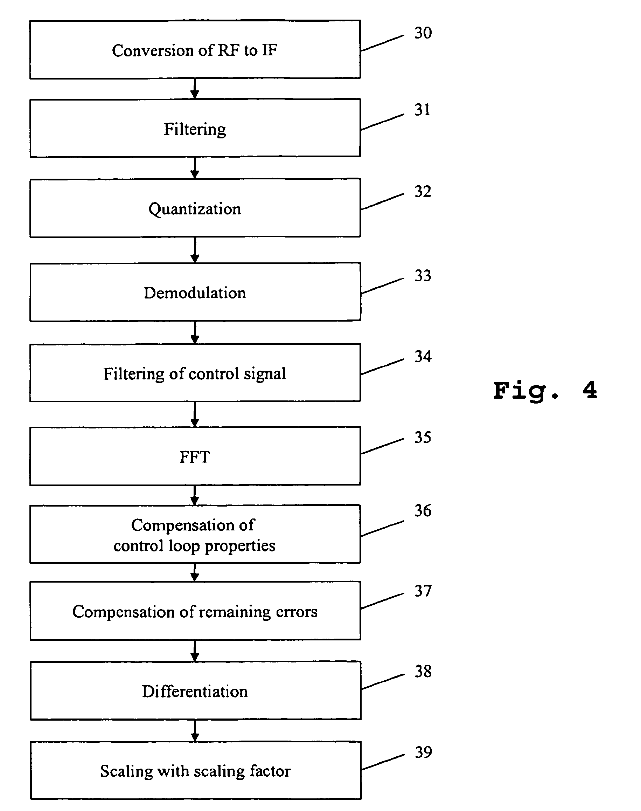

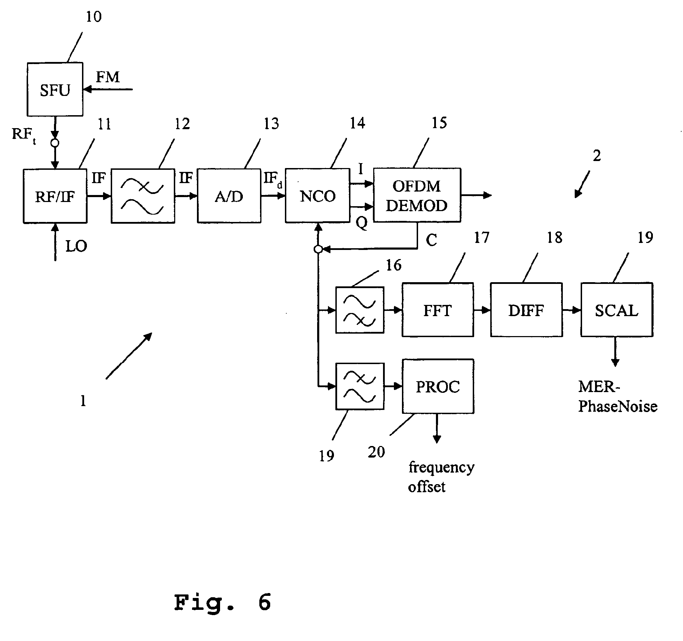

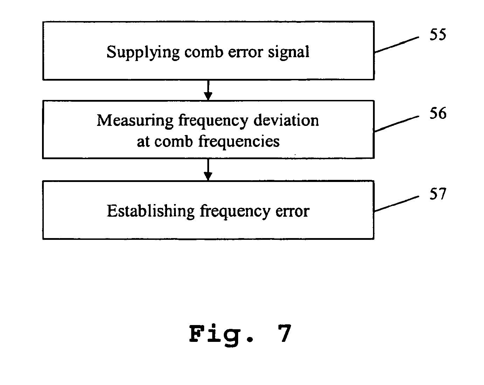

First we demonstrate the underlying concept of the present invention and the function of an exemplary inventive device with respect to Fig. 1 to Fig. 3. In a second step the function of an exemplary inventive method is shown with respect to Fig. 4 to Fig. 5. In a last step the function of a configuration method is shown with respect to Fig. 6 and Fig. 7. Similar entities and reference numbers in different figures have been partially omitted.

Fig. 1 shows an exemplary embodiment of the inventive device. A local oscillator signal LO is supplied to a mixer 11. A measurement signal RF is further supplied to the mixer 11. The measurement signal RF is generated for example by a test signal generator. The mixer 11 mixes the measurement RF signal with the local oscillator signal LO. The measurement signal RF is therefore transformed into an intermediate frequency signal IF. The mixing results in a low frequency component and a high frequency component within the intermediary frequency signal IF. The signal IF is supplied to a low pass filter 12. The filter cutoff of the low pass filter 12 is just above the low frequency component. Therefore only the low frequency component is passed on to an analog-digital-converter 13. The analog-digital-converter 13 converts the analog intermediate frequency IF signal into a digital intermediate frequency signal $IF_d$.

The digital intermediate frequency signal $IF_d$ is supplied to a numerical controlled oscillator 14. The numerical controlled oscillator 14 mixes the digital intermediate frequency signal $IF_d$ with an oscillator signal and with an oscillator signal which is phase shifted by 90 degrees. The numerical controlled oscillator 14 therefore produces an inphase component I and a quadrature component Q. These Signals I, Q are supplied to a demodulator 15, which demodulates the OFDM baseband signals I, Q to a binary data stream. The demodulator 15 additionally generates a control signal C which is fed back to the numerical controlled oscillator 14. The control signal C is equivalent to the frequency deviation of the numerical controlled oscillator 14. The control loop between the demodulator 15 and the numerical controlled oscillator 14 therefore stabilizes the oscillator signal of the numerical controlled oscillator 14.

The control signal C is further fed to a high pass filter 16 and a low pass filter 19. The high pass filter 16 removes low frequency components of the control signal C and feeds the resulting high frequency component to transformation means 17. The mixer 11, the low pass filter 12, the analog-digital-converter 13, the numerically controlled oscillator 14, the demodulator 15, the high pass filter 18 and the low pass filter 19 are considered to be part of first signal processing 1 means. The transformation means 17 are preferably realized as a fast fourier transformation unit here. The transformation means 17 transform the signal into the frequency domain. This is achieved here by performing a fourier transformation according to the fast fourier transformation (FFT) algorithm. A frequency deviation spectrum of the high frequency component is therefore generated by the transformation means 17.

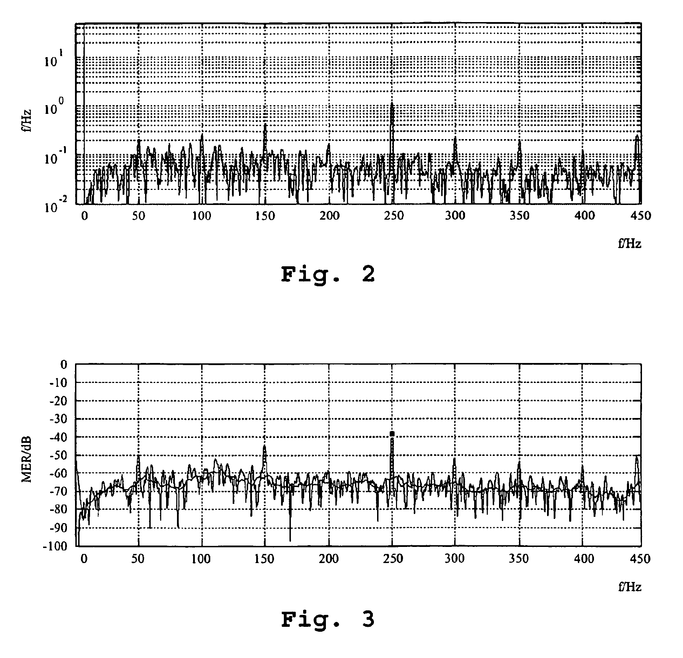

Such a spectrum can be seen in Fig. 2. Clearly visible are especially high frequency deviations at 150Hz and 250Hz. This spectrum is passed on to differentiation means 18 which differentiate the spectrum resulting in a phase noise (deviation) spectrum. Since the phase noise spectrum is directly proportional to the MER-Phase-Noise spectrum, the MER-Phase-Noise spectrum can be derived by merely scaling the phase noise spectrum using a scaling unit 19. The transformation means 17, the differentiation means 18 and the scaling means 19 are considered to be part of second signal processing means 2.

The MER-phase noise spectrum is the modulation error ratio displayed over the frequency. The modulation error ratio is calculated by the following formula:

$$MER = 10 \log \frac{\frac{1}{N} \sum_n error\ vector}{(ideal\ signal)^2}$$

By means of further compensation algorithms, specifics of the used hardware can be eliminated from the measurement result. These compensation algorithms are performed by the transformation means 17 after the transformation to the frequency domain. This results in a representation of the frequency error spectrum, independent of any internal hardware of software settings. The frequency can be calculated from close to DC up to half of the OFDM carrier spacing,

$$\frac{1}{[2 * (T_u + T_g)]},$$

with $T_u$ = active symbol duration and Tg = guard interval duration. Again, the frequency of the phase error spectrum can be calculated up to half of the OFDM-subcarrier spacing. This means that phase noise interferers can be detected up to several 100Hz, in case of 8K FFT OFDM Signals.

It was found that the integrated frequency jitter value is directly proportional to the degradation of a DVB-T signal due to phase noise in terms of MER. Therefore it is also possible to directly convert the results from above into MER values. As these values are mainly determined by phase noise, we call them simply MER-Phase-Noise.

Fig. 3 shows MER-Phase-Noise over the frequency. In this image phase distortions on the MER result can directly be seen. When looking to the peek at 250Hz, this part alone stands for a lowering of the MER down to 38.5dB. This value assumes that no further distortions are applied. But other components are also present in the signal at e.g. 50Hz and 150Hz. The overall impact on the MER due to phase distortions (= MER-Phase-Noise) is the integrated value of the curve. It was computed in this calculation with 35.15dB. Indeed, an overall MER = 34dB is measured under these conditions, including all other impairments. Therefore, this measurement clearly indicates that there is a phase noise issue with the incoming signal. This computation is mainly sensitive for phase noise components. In case of pure AWGN noise (C/N = 20 dB), the integrated MER-Phase-Noise value is > 50dB.

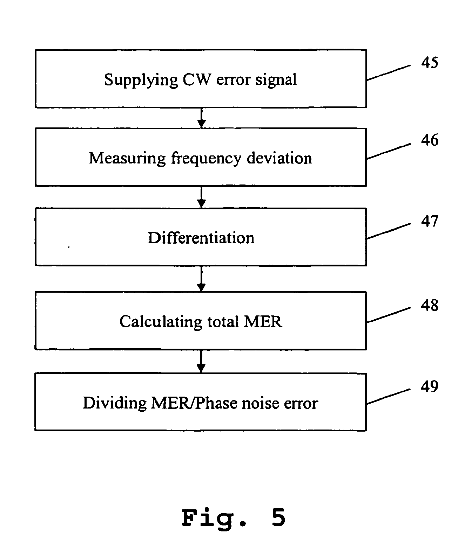

For estimating the scaling factor used by the scaling unit 19 we refer to the section dealing with Fig. 5. The control signal produced by the demodulator 15 is further supplied to a low pass filter 19, which removes the high frequency components of the control signal. The low frequency component of the control signal is passed on to a processing unit 20 which calculates the frequency offset exhibited by the numerical controlled oscillator 14. This though is not relevant for the present invention.

Fig. 4 shows a first exemplary embodiment of the inventive method. In a first step 30 a test signal RF is converted to an intermediate frequency signal IF by mixing it with a local oscillator signal LO. In a second step 31 undesired components of the mixed signal are filtered. For example only a low frequency component remains. In a third step 32 a quantization is performed. The signal is also digitized in this step. In a fourth step 33 the signal is demodulated. The resulting signal is a baseband signal composed of an in phase component I and a quadrature component Q. This signal I, Q though is of no further use for the inventive method. During the demodulation further a control signal C is generated, which indicates the frequency deviation of the signal prior to demodulation. This control signal C is transformed into the frequency domain in a sixth step 35 using the fast fourier transformation algorithm. The control loop described earlier comprises certain non-ideal properties, e.g. a time lag. These control loop properties are compensated in a seventh step 36. Since the properties of the control loop are identical from one test receiver to another no measurements have to be performed in this step. The compensation is merely a numerical process.

In an eighth step 37 a remaining error which cannot be compensated using control loop parameters is corrected. The parameters necessary for this numerical correction are obtained by a separate configuration measurement described in Fig. 6 and 7. This configuration measurement has to be performed once for each individual test receiver. The resulting signal after this step is a frequency deviation spectrum. In a ninth step 38 a differentiation is performed. The resulting signal after this step is a phase deviation spectrum. This is equivalent to a phase noise spectrum. A phase noise spectrum though is displayed using rather unhandy units. In a tenth step 39 a scaling of the phase noise spectrum using a constant scaling factor is performed. Since the modulation error ratio MER is directly proportional to the phase noise the resulting signal is a modulation error ratio spectrum further referred to as MER-Phase-Noise. This signal is displayed in dB over Hz which are very handy units.

In Fig. 5 a second exemplary embodiment of the inventive method is displayed. The method displayed in Fig. 5 deals with calculating the scaling factor used by the scaling unit 19 from Fig. 1 and by the scaling step 39 from Fig. 4. In a first step 45 a known continuous wave error signal is mixed with a known OFDM test signal. The resulting signal is input into the test receiver. In a second step 46 the frequency deviation of the signal prior to demodulation is measured as shown in Fig. 4. In a third step 47 a differentiation is performed resulting in a phase noise spectrum. In a forth step 48 the total modulation error ratio MER is calculated using the known OFDM signal and the known continuous wave error signal. In a fifth step 49 the calculated MER is divided by the measured phase noise error resulting in the scaling factor.

It has been shown that this scaling factor is independent from the frequency of the continuous wave error signal. Therefore an identical scaling factor can be used for arbitrary error signals. The scaling factor though is dependent on the type of fast fourier transformation that is performed. Therefore for each type of FFT a different scaling factor has to be determined.

Fig. 6 and Fig. 7 show a third exemplary embodiment of the inventive method and a second embodiment of the inventive device. These deal with analyzing and compensating for remaining frequency error of the control loop. Fig. 6 corresponds to Fig. 1 apart from the measurement signal RF being replaced by a test signal RF$_t$, which is supplied by a test signal generator 10. The test signal RF$_t$ can be modulated by the test signal generator 10.

In a first step 55 a comb error signal FM is mixed with a known OFDM test signal resulting in a known modulated test signal RF$_t$. The resulting signal RF$_t$ is transformed into an intermediate frequency signal IF with known error components at known frequency locations. This signal is supplied to the filter 12 of the test receiver according to Fig. 1 and 6. A measurement of the frequency deviation is performed in a second step 56. Therefore the frequency deviation at the known comb frequencies is measured. In a third step 57 the remaining frequency error is calculated from this remaining frequency deviation at the comb frequencies. This remaining frequency error represents a frequency response. Since the components of the inventive device are rather stable over time and digital components are concerned here, this measurement only has to be performed once for the entirety of test receivers. This measurement is limited to ½ of the carrier distance since the frequency deviation would overlap with the neighboring carrier otherwise.

The invention is not limited to the examples shown above. The invention discussed above can be applied to many signal formats. The characteristics of the exemplary embodiments can be used in any combination.

**Claims**

1. Device for measuring phase noise in an OFDM signal comprising first signal processing means (1), second signal processing means (2),
   wherein the second signal processing means (2) comprise scaling means (19), wherein the first signal processing (1) means are composed for determining a frequency deviation of the OFDM signal over time,
   wherein the second signal processing (2) means are composed for transforming the frequency deviation into the frequency domain,
   wherein the second signal processing (2) means are composed for thereby determining a phase deviation of the OFDM signal over a frequency range wherein the scaling means (19) are composed for scaling the phase deviation to a modulation error rate over a frequency range using a scaling factor,
   wherein the phase deviation corresponds to the measured phase noise,
   wherein the second signal processing (2) means comprise transformation means (17),
   wherein the first signal processing (1) means comprise a numerically controlled oscillator (14) and a demodulator (15),
   wherein the demodulator (15) is composed for controlling the numerically controlled oscillator (14) using a control signal (C), and
   wherein the frequency deviation of the OFDM signal over time is determined from this control signal (C).

**2.** Device according to claim 1,
**characterized in that**
the second signal processing (2) means further comprise differentiation means (18),
the transformation means (17) are composed for transforming the frequency deviation into the frequency domain,
the transformation means (17) are further composed for afterwards compensating for errors, and the differentiation means (18) are composed for differentiating the error compensated frequency deviation resulting in the phase deviation.

**3.** Device according to claim 1,
**characterized in that**
the transformation means (17) are further composed for afterwards compensating for known properties of a control loop formed by the numerically controlled oscillator (14) and the demodulator (15).

**4.** Device according to claim 3,
**characterized in that**
the transformation means (17) are composed for compensating for remaining error sources which cannot be compensated using control loop parameters using a predetermined frequency response.

**5.** Device according to claim 4,
**characterized in that**
the device is composed for determining the predetermined frequency response,
a test signal generator (10) comprised by the device, is composed for suppling a known test signal ($RF_t$) modulated with a known error (FM) signal to the device,
the device is composed for measuring the known test signal ($RF_t$),
the device is further composed for determining the frequency response from the known test signal ($RF_t$) and the measured test signal,
the known error signal is a continuous wave signal or a comb signal in the frequency domain.

**6.** Device according to any of the claims 1 to 5,
**characterized in that**
the device is composed for determining the scaling factor, a test signal generator (10) comprised by the device is composed for supplying a known test signal ($RF_t$) modulated with a known continuous wave error signal (FM) to the device,
the device is composed for determining the phase deviation of the known test signal ($RF_t$),
the device is composed for calculating a modulation error ratio of the known test signal ($RF_t$), and
the device is composed for calculating the scaling factor by dividing the modulation error ratio by the phase deviation.

**7.** Method for measuring phase noise in an OFDM signal, wherein the following steps are performed:

- determining a frequency deviation of the OFDM signal over time,
- transforming the frequency deviation into the frequency domain,
- thereby determining a phase deviation of the OFDM signal over a frequency range,
- scaling the phase deviation to a modulation error rate over a frequency range using a scaling factor,

wherein the phase deviation corresponds to the measured phase noise,
wherein an intermediary frequency ($IF_d$) signal obtained from the OFDM signal is mixed with an oscillator signal and the oscillator signal phase-shifted by 90°,
wherein resulting signals (I, Q) are demodulated,
wherein the demodulation controls the oscillator signal using a control signal (C), and
wherein frequency deviation of the OFDM signal over time is determined from this control signal (C).

**8.** Method according to claim 7,
**characterized in that**
afterwards errors are compensated for, and
the error compensated frequency deviation is differentiated resulting in the phase deviation.

**9.** Method according to claim 7,
**characterized in that**
the known properties of a control loop formed by the mixing with the oscillator signal and the demodulation are compensated for afterwards.

**10.** Method according to claim 9,
**characterized in that**
remaining error sources which cannot be compensated using control loop parameters are compensated for using a predetermined frequency response.

**11.** Method according to claim 10,
**characterized in that**
the predetermined frequency response is determined,
a known test signal ($RF_t$) modulated with a known error (FM) signal is supplied,
the known test signal ($RF_t$) is measured,
the frequency response is determined from the known test signal ($RF_t$) and the measured test signal,
the known error signal is a continuous wave signal or a comb signal in the frequency domain.

**12.** Method according to any of the claims 7 to 11,
**characterized in that**
the scaling factor is determined,

a known test signal ($RF_t$) modulated with a known continuous wave error signal (FM) is supplied,
the phase deviation of the known test signal ($RF_t$) is determined,
a modulation error ratio of the known test signal ($RF_t$) is calculated, and
the scaling factor is calculated by dividing the modulation error ratio by the phase deviation.

**Patentansprüche**

1. Vorrichtung zum Messen von Phasenrauschen in einem OFDM-Signal, umfassend erste Signalverarbeitungseinrichtungen (1), zweite Signalverarbeitungseinrichtungen (2),
   wobei die zweiten Signalverarbeitungseinrichtungen (2) Skalierungseinrichtungen (19) umfassen,
   wobei die ersten Signalverarbeitungseinrichtungen (1) zum Bestimmen einer Frequenzabweichung des OFDM-Signals über die Zeit gebildet sind,
   wobei die zweiten Signalverarbeitungseinrichtungen (2) zum Transformieren der Frequenzabweichung in den Frequenzbereich gebildet sind,
   wobei die zweiten Signalverarbeitungseinrichtungen (2) gebildet sind, um dadurch eine Phasenabweichung des OFDM-Signals über einen Frequenzbereich zu bestimmen,
   wobei die Skalierungseinrichtungen (19) zum Skalieren der Phasenabweichung unter Heranziehung eines Skalierungsfaktors in eine Modulations-Fehlerrate über einen Frequenzbereich gebildet sind,
   wobei die Phasenabweichung dem gemessenen Phasenrauschen entspricht,
   wobei die zweiten Signalverarbeitungseinrichtungen (2) Transformationseinrichtungen (17) umfassen,
   wobei die ersten Signalverarbeitungseinrichtungen (1) einen numerisch gesteuerten Oszillator (14) und einen Demodulator (15) umfassen,
   wobei der Demodulator (15) zum Steuern des numerisch gesteuerten Oszillators (14) unter Heranziehung eines Steuersignals (C) gebildet ist
   und wobei die Frequenzabweichung des OFDM-Signals über die Zeit aus diesem Steuersignal (C) bestimmt wird.

2. Vorrichtung nach Anspruch 1,
   **dadurch gekennzeichnet,**
   **dass** die zweiten Signalverarbeitungseinrichtungen (2) ferner Differenziereinrichtungen (18) umfassen,
   **dass** die Transformationseinrichtungen (17) zum Transformieren der Frequenzabweichung in den Frequenzbereich gebildet sind, dass die Transformationseinrichtungen (17) ferner für eine nachträgliche Kompensation von Fehlern gebildet sind und dass die Differenziereinrichtungen (18) zum Differenzieren der fehlerkompensierten Frequenzabweichung gebildet sind, die zu der Phasenabweichung führt.

3. Vorrichtung nach Anspruch 1,
   **dadurch gekennzeichnet,**
   **dass** die Transformationseinrichtungen (17) ferner für eine nachträgliche Kompensation bekannter Eigenschaften einer durch den numerisch gesteuerten Oszillator (14) und den Demodulator (15) gebildeten Steuerungsschleife gebildet sind.

4. Vorrichtung nach Anspruch 3,
   **dadurch gekennzeichnet,**
   **dass** die Transformationseinrichtungen (17) zum Kompensieren von Restfehlerquellen gebildet sind, die durch Heranziehen von Steuerungsschleifenparametern unter Nutzung eines bestimmten Frequenzganges nicht kompensiert werden können.

5. Vorrichtung nach Anspruch 4,
   **dadurch gekennzeichnet,**
   **dass** die Vorrichtung zum Bestimmen des bestimmten Frequenzganges gebildet ist,
   **dass** ein von der Vorrichtung umfasster Testsignalgenerator (10) zur Lieferung eines mit einem bekannten Fehlersignal (FM) modulierten bekannten Testsignals ($RF_t$) an die Vorrichtung gebildet ist,
   **dass** die Vorrichtung zum Messen des bekannten Testsignals ($RF_t$) gebildet ist,
   **dass** die Vorrichtung ferner zum Bestimmen des Frequenzganges aus dem bekannten Testsignal ($RF_t$) und dem gemessenen Testsignal gebildet ist, und **dass** das bekannte Fehlersignal ein Dauerstrichsignal oder ein Kammsignal im Frequenzbereich ist.

6. Vorrichtung nach einem der Ansprüche 1 bis 5, **dadurch gekennzeichnet,**
   **dass** die Vorrichtung zum Bestimmen des Skalierungsfaktors gebildet ist,
   **dass** ein von der Vorrichtung umfasster Testsignalgenerator (10) zur Lieferung eines mit einem bekannten Dauerstrich-Fehlersignal (FM) modulierten bekannten Testsignals ($RF_t$) an die Vorrichtung gebildet ist,
   **dass** die Vorrichtung zum Bestimmen der Phasenabweichung des bekannten Testsignals ($RF_t$) gebildet ist,
   **dass** die Vorrichtung zum Berechnen eines Modulations-Fehlerverhältnisses des bekannten Testsignals ($RF_t$) gebildet ist
   und **dass** die Vorrichtung zum Berechnen des Skalierungsfaktors durch Dividieren des Modulations-Fehlerverhältnisses durch die Phasenabweichung gebildet ist.

7. Verfahren zum Messen von Phasenrauschen in einem OFDM-Signal, wobei die folgenden Schritte ausgeführt werden:

- Bestimmen einer Frequenzabweichung des OFDM-Signals über die Zeit,
- Transformieren der Frequenzabweichung in den Frequenzbereich,
- dadurch Bestimmen einer Phasenabweichung des OFDM-Signals über einen Frequenzbereich,
- Skalieren der Phasenabweichung zu einer Modulations-Fehlerrate über einen Frequenzbereich unter Heranziehung eines Skalierungsfaktors,

wobei die Phasenabweichung dem gemessenen Phasenrauschen entspricht,
wobei ein aus dem OFDM-Signal erhaltenes Zwischenfrequenzsignal ($IF_d$) mit einem Oszillatorsignal gemischt wird und das Oszillatorsignal in der Phase um 90° verschoben wird,
wobei resultierende Signale (I, Q) demoduliert werden,
wobei die Demodulation das Oszillatorsignal unter Heranziehung eines Steuersignals (C) steuert
und wobei die Frequenzabweichung des OFDM-Signals über die Zeit aus diesem Steuersignal (C) bestimmt wird.

8. Verfahren nach Anspruch 7,
**dadurch gekennzeichnet,**
**dass** Fehler nachträglich kompensiert werden
und **dass** die fehlerkompensierte Frequenzabweichung unter Lieferung der Phasenabweichung differenziert wird.

9. Verfahren nach Anspruch 7,
**dadurch gekennzeichnet,**
**dass** die bekannten Eigenschaften einer durch Mischen mit dem Oszillatorsignal und die Demodulation gebildeten Steuerungsschleife nachträglich kompensiert werden.

10. Verfahren nach Anspruch 9,
**dadurch gekennzeichnet,**
**dass** Restfehlerquellen, die durch Heranziehen von Steuerungsschleifenparametern nicht kompensiert werden können, unter Nutzung eines bestimmten Frequenzganges kompensiert werden.

11. Verfahren nach Anspruch 10,
**dadurch gekennzeichnet,**
**dass** der bestimmte Frequenzgang bestimmt wird,
**dass** ein mit einem bekannten Fehlersignal (FM) moduliertes bekanntes Testsignal ($RF_t$) abgegeben wird,
**dass** das bekannte Testsignal ($RF_t$) gemessen wird,
**dass** der Frequenzgang aus dem bekannten Testsignal ($RF_t$) und dem gemessenen Testsignal bestimmt wird
und **dass** das bekannte Fehlersignal ein Dauerstrichsignal oder ein Kammsignal im Frequenzbereich ist.

12. Verfahren nach einem der Ansprüche 7 bis 11,
**dadurch gekennzeichnet,**
**dass** der Skalierungsfaktor bestimmt wird,
**dass** ein mit einem bekannten Dauerstrich-Fehlersignal (FM) moduliertes bekanntes Testsignal ($RF_t$) abgegeben wird,
**dass** die Phasenabweichung des bekannten Testsignals ($RF_t$) bestimmt wird,
**dass** ein Modulations-Fehlerverhältnis des bekannten Testsignals ($RF_t$) berechnet wird
und **dass** der Skalierungsfaktor durch Dividieren des Modulations-Fehlerverhältnisses durch die Phasenabweichung berechnet wird.

**Revendications**

1. Dispositif pour mesurer un bruit de phase dans un signal OFDM comportant un premier moyen de traitement de signal (1), un second moyen de traitement de signal (2),
dans lequel le second moyen de traitement de signal (2) comporte un moyen de mise à l'échelle (19), dans lequel le premier moyen de traitement de signal (1) est constitué pour déterminer une déviation de fréquence du signal OFDM dans le temps,
dans lequel le second moyen de traitement de signal (2) est constitué pour transformer la déviation de fréquence dans le domaine de fréquence,
dans lequel le second moyen de traitement de signal (2) est constitué pour déterminer ainsi une déviation de phase du signal OFDM dans une plage de fréquences où le moyen de mise à l'échelle (19) est constitué pour mettre à l'échelle la déviation de phase au taux d'erreur de modulation sur une plage de fréquences en utilisant un facteur de mise à l'échelle,
dans lequel la déviation de phase correspond au bruit de phase mesuré,
dans lequel le second moyen de traitement de signal (2) comporte un moyen de transformation (17),
dans lequel le premier moyen de traitement de signal (1) comporte un oscillateur contrôlé numériquement (14) et un démodulateur (15),
dans lequel le démodulateur (15) est constitué pour contrôler l'oscillateur contrôlé numériquement (14) en utilisant un signal de contrôle (C), et
dans lequel la déviation de fréquence du signal OFDM dans le temps est déterminée à partir de ce signal de contrôle (C).

2. Dispositif selon la revendication 1, **caractérisé en ce que**
le second moyen de traitement de signal (2) comporte en outre un moyen de différenciation (18),
le moyen de transformation (17) est constitué pour transformer la déviation de fréquence dans le domaine de fréquence,
le moyen de transformation (17) est en outre constitué pour compenser par la suite des erreurs, et le moyen de différenciation (18) est constitué pour différencier la déviation de fréquence à compensation d'erreur ayant pour résultat la déviation de phase.

3. Dispositif selon la revendication 1, **caractérisé en ce que**
le moyen de transformation (17) est en outre constitué pour compenser par la suite des propriétés connues d'une boucle de commande formée par l'oscillateur contrôlé numériquement (14) et le démodulateur (15).

4. Dispositif selon la revendication 3, **caractérisé en ce que**
le moyen de transformation (17) est constitué pour compenser des sources d'erreur restantes qui ne peuvent pas être compensées en utilisant les paramètres de boucle de commande en utilisant une réponse de fréquence prédéterminée.

5. Dispositif selon la revendication 4, **caractérisé en ce que**
le dispositif est constitué pour déterminer la réponse de fréquence prédéterminée,
un générateur de signal test (10) inclus dans le dispositif est constitué pour délivrer un signal test connu ($RF_t$) modulé avec un signal d'erreur connu (FM) au dispositif,
le dispositif est constitué pour mesurer le signal test connu ($RF_t$),
le dispositif est en outre constitué pour déterminer la réponse de fréquence à partir du signal test connu ($RF_t$) et du signal test mesuré,
le signal d'erreur connu est un signal d'onde continue ou un signal en peigne dans le domaine de fréquence.

6. Dispositif selon l'une quelconque des revendications 1 à 5, **caractérisé en ce que**
le dispositif est constitué pour déterminer le facteur de mise à l'échelle, un générateur de signal test (10) inclus dans le dispositif est constitué pour délivrer un signal test connu ($RF_t$) modulé avec un signal d'erreur d'onde continue connu (FM) au dispositif,
le dispositif est constitué pour déterminer la déviation de phase du signal test connu ($RF_t$),
le dispositif est constitué pour calculer un taux d'erreur de modulation du signal test connu ($RF_t$), et
le dispositif est constitué pour calculer le facteur de mise à l'échelle en divisant le rapport d'erreur de modulation par la déviation de phase.

7. Procédé pour mesurer un bruit de phase dans un signal OFDM, dans lequel les étapes suivantes sont effectuées :

   - déterminer une déviation de fréquence du signal OFDM dans le temps,
   - transformer la déviation de fréquence dans le domaine de fréquence,
   - déterminer ainsi une déviation de phase du signal OFDM sur une plage de fréquences,
   - mettre à l'échelle la déviation de phase au taux d'erreur de modulation sur une plage de fréquences en utilisant un facteur de mise à l'échelle,

   dans lequel la déviation de phase correspond au bruit de phase mesuré,
   dans lequel une fréquence intermédiaire ($IF_d$) obtenue à partir du signal OFDM est mélangée avec un signal d'oscillateur et le signal d'oscillateur décalé de 90°,
   dans lequel les signaux résultants (I, Q) sont démodulés,
   dans lequel la démodulation contrôle le signal d'oscillateur en utilisant un signal de contrôle (C), et
   dans lequel la déviation de fréquence du signal OFDM dans le temps est déterminée à partir de ce signal de contrôle (C).

8. Procédé selon la revendication 7, **caractérisé en ce que**
par la suite des erreurs sont compensées, et
la déviation de fréquence à compensation d'erreur est différenciée ayant pour résultat la déviation de phase.

9. Procédé selon la revendication 7, **caractérisé en ce que**
les propriétés connues d'une boucle de commande formée par le mélange avec le signal d'oscillateur et la démodulation sont compensées par la suite.

10. Procédé selon la revendication 9, **caractérisé en ce que**
des sources d'erreur restantes qui ne peuvent pas être compensées en utilisant des paramètres de boucle de commande sont compensées en utilisant une réponse de fréquence prédéterminée.

11. Procédé selon la revendication 10, **caractérisé en ce que**
la réponse de fréquence prédéterminée est déterminée,
un signal test connu ($RF_t$) modulé avec un signal d'erreur connu (FM) est délivré,
le signal test connu ($RF_t$) est mesuré,
la réponse de fréquence est déterminée à partir du signal test connu ($RF_t$),

le signal d'erreur connu est un signal d'onde continue ou un signal en peigne dans le domaine de fréquence.

12. Procédé selon l'une quelconque des revendications 7 à 11, **caractérisé en ce que**
le facteur de mise à l'échelle est déterminé,
un signal test connu ($RF_t$) modulé avec un signal d'erreur d'onde continue connu (FM) est délivré,
la déviation de phase du signal test connu ($RF_t$) est déterminée,
un rapport d'erreur de modulation du signal test connu ($RF_t$) est calculé, et
le facteur de mise à l'échelle est calculé en divisant le rapport d'erreur de modulation par la déviation de phase.

**Fig. 1**

Fig. 2

Fig. 3

Fig. 4

| Supplying CW error signal | 45 |
| Measuring frequency deviation | 46 |
| Differentiation | 47 |
| Calculating total MER | 48 |
| Dividing MER/Phase noise error | 49 |

Fig. 5

**Fig. 6**

| Supplying comb error signal | 55 |

↓

| Measuring frequency deviation at comb frequencies | 56 |

↓

| Establishing frequency error | 57 |

# Fig. 7

**EP 2 388 601 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102006019759 A1

**Non-patent literature cited in the description**

- **ANGRISANI L et al.** A Digital Signal Processing Instrument for Real-time phase noise Measurement. *IEEE Transactions on Center,* 01 October 2008, vol. 55 (10), 2098-2107